# EUROPEAN PATENT SPECIFICATION

(11) **EP 3 056 303 B1**
(45) Date of publication and mention of the grant of the patent: **25.09.2019**
(21) Application number: 13895403.7
(22) Date of filing: 09.10.2013
(51) Int. Cl.: B22F 7/08, B22F 7/06, B23K 35/22, H01L 23/00, B23K 35/02, B22F 3/16

(54) **METHOD FOR BONDING METAL BODIES AND BONDING STRUCTURE FOR METAL BODIES**
VERFAHREN ZUM VERBINDEN EINES METALLKÖRPERS UND VERBINDUNGSSTRUKTUR FÜR EINEN METALLKÖRPER
PROCÉDÉ D'ASSEMBLAGE POUR CORPS MÉTALLIQUE ET STRUCTURE D'ASSEMBLAGE POUR CORPS MÉTALLIQUE

(43) Date of publication of application: 17.08.2016
(73) Proprietor: Furukawa Electric Co., Ltd., Chiyoda-ku Tokyo 100-8322 (JP); Fuji Electric Co., Ltd., Kawasaki-shi, Kanagawa 210-9530 (JP)
(72) Inventor: KOJIMA, Naoyuki, Tokyo 100-8322 (JP); SATO, Shunichiro, Tokyo 100-8322 (JP); HIKASA, Kazuhito, Tokyo 100-8322 (JP); FUJIWARA, Hidemichi, Tokyo 100-8322 (JP); SHIOKAWA, Kunio, Kawasaki-shi Kanagawa 210-9530 (JP); ASAI, Tatsuhiko, Kawasaki-shi Kanagawa 210-9530 (JP); HOKAZONO, Hiroaki, Kawasaki-shi Kanagawa 210-9530 (JP)
(74) Representative: advotec.
(86) International application number: PCT/JP2013/077458
(87) International publication number: WO 2015/052791

(56) References cited:
- JP-A- H0 285 307
- JP-A- S4 946 556
- JP-A- S5 464 051
- JP-A- 2004 107 728
- JP-A- 2008 161 907
- JP-A- 2011 094 223
- JP-A- 2011 236 494
- JP-A- 2013 143 243
- JP-A- 2013 209 720
- US-A1- 2008 173 398

## Description

### TECHNICAL FIELD

The present invention relates to a method for bonding metal bodies and a bonding structure of metal bodies, and more particularly, to a method for bonding metal bodies in a case in which the metal body is an electrode for a semiconductor element, an electrode or a lead frame of a circuit board or a ceramic substrate, or the like, and to a bonding structure of the metal bodies.

### BACKGROUND ART

For the connection between a semiconductor element that implements the control or supply of electric power (so-called power semiconductor element), and a substrate such as a circuit board or a ceramic substrate, or a wiring body such as a lead frame, solder is generally used as bonding materials. Regarding such solder, cream solder produced by adding flux to a powder of solder and regulating the mixture to have an appropriate viscosity is mainly used. However, when flux is used, there is a possibility that the semiconductor element surface may be contaminated due to the flux in the solder, and therefore a cleaning process is required. Furthermore, in recent years, it has been required to use a lead-free solder material which does not contain lead for the environment. As a lead-free solder material capable of coping with the heat generated by power semiconductors, an Au-Sn-based solder is available; however, it is not practically useful since this solder is expensive. As a solder material which is less expensive than the Au-Sn-based solder, a Sn-Ag-Cu-based solder is available; however, this solder has another problem that the growth of an intermetallic compound caused by thermal history leads to a decrease in reliability.

As a bonding member which does not use solder, an anisotropic conductive film (ACF) is available, the ACF can be obtained by molding a mixture of a thermosetting resin and fine metal particles having electrical conductivity into a film form. However, the ACF is not suitable for the connection of a power semiconductor having a large amount of heat generation since there is concern about deterioration of the thermosetting resin caused by high temperature.

Thus, as another bonding member which does not contain solder, it has been proposed to use an Ag paste in which Ag particles are dispersed in a resin. In a case in which an Ag paste is used as a bonding member of a power semiconductor, since high thermal conductivity and high electrical conductivity are required, it is necessary to use a large content of Ag in the paste. However, if the content of Ag increases, the proportion of the resin which influences elastic deformation is decreased. Therefore, rigidity of the bonding layer after a curing treatment increases, and the strain absorption capacity of the bonding layer is decreased. When a strain exceeding the strain absorption capacity is applied to this bonding layer, defects arise in the contact interface between an electrode of a semiconductor element or a die pad and Ag particles, or in the connection material, and the defects lead to detachment of the connected layers.

Furthermore, in a case in which an electrode of a semiconductor element or an electrode of a substrate is formed of Ni, when an Ag paste is used as a bonding member, there is a possibility that the bonding strength (adhesiveness) becomes low, and the contact interface might be fractured by an external force at the time of handling it, or the required long-term reliability could not be obtained. Therefore, it is necessary to subject an electrode of a semiconductor element or an electrode of a substrate to plating with a noble metal. However, when bonding is achieved by providing plating with a noble metal as such, the thermal stress on the semiconductor chip caused by a difference in thermal expansion between the members is increased, and therefore, there is a problem that durability is deteriorated.

Furthermore, recently, it is known to perform bonding by supplying metal particles having the surface coated with an organic substance and having an average particle size of 100 nm or less, interface between materials to be bonded, decomposing the organic substance by heating, and sintering the metal particles (see, for example, Patent Document 1).

Furthermore, it has been proposed to bond materials, by forming an oxide layer containing oxygen at the bonding interface of the materials to be bonded; disposing, at this bonding interface, a bonding material containing metal compound particles having an average particle size of from 1 nm to 50 µm and a reducing agent formed from an organic substance, and heating and pressurizing these materials to be bonded (for example, Patent Document 2). Regarding this bonding material, it is considered that the metal compound particles are reduced at a temperature lower than the temperature at which simple metal compound particles are heated and decomposed, and at that time, metal particles having an average particle size of 100 nm or less are produced. Furthermore, it is considered that when an oxide layer is produced at the bonding surface in advance before bonding, and then the layer is subjected to an oxidation treatment to produce an oxide layer having a thickness larger than or equal to the thickness of a natural oxide film, discharge of the organic substance in the bonding material at the time of bonding can be carried out efficiently, and thereby the shear strength of the bonding surface can be increased.

### CITATION LIST

### PATENT DOCUMENT

Patent Document 1: JP 2004-107728 A
Patent Document 2: JP 2008-208442 A

### SUMMARY OF THE INVENTION

### PROBLEM TO BE SOLVED BY THE INVENTION

However, in regard to the bonding methods described in Patent Document 1 and Patent Document 2, in the bonding by means of fine metal particles, the bonding between the fine metal particles and a metal body as a material to be bonded, has a problem that a diffusion reaction does not easily proceed, and the adhesive force is weak, as compared to the bonding between the fine metal particles.

Thus, it is an object of the invention to provide a method for bonding metal bodies with excellent adhesive force, and a bonding structure of metal bodies having excellent adhesive force.

### MEANS FOR SOLVING PROBLEM

In order to achieve the object such as described above, the method for bonding metal bodies according to the invention includes a step of preparing a first material to be bonded, which is formed from a metal and has a processed layer that has been subjected to a processing for creating atomic vacancies and/or dislocations; a step of supplying fine metal particles between the processed layer of the first material to be bonded and a second material to be bonded; and a step of bonding the first material to be bonded and the second material to be bonded, by means of the fine metal-particles. The process for creating atomic vacancies and/or dislocations is mechanical processing or radiation damage by irradiation with particle beams. A Vickers hardness number of the processed layer is higher by Hv 50 or more than a Vickers hardness number of the metal before processing and is from Hv 80 to Hv 120. The Vickers hardness number of the processed layer can be checked by the Vickers hardness test of JIS Z 2244, in case in which the layer is less than 1 µm thick by nanoindentation. A thickness of the processed layer is 0.5 µm or more. The first material to be bonded is formed from copper or a copper alloy, silver plating or gold plating. The fine metal particles are fine particles of one metal selected from a metal element group consisting of silver, gold, copper, aluminum, nickel, platinum, tin, antimony and palladium; fine particles obtained by mixing two or more kinds selected from the metal element group; fine particles formed from an alloy of two or more elements selected from the metal element group; fine particles obtained by mixing fine particles of one metal selected from the metal element group or fine particles produced by mixing two or more kinds selected from the metal element group, with fine particles formed from an alloy of two or more elements selected from the metal element group; or an oxide of these fine particles. The processed layer of the first material to be bonded is recrystallized by heating the first material to be bonded to a temperature higher than or equal to the recrystallization temperature of the processed layer of the first material to be bonded..

Also, it is preferable for the method for bonding metal bodies related to the invention that the processed layer is formed only on the surface of the materials to be bonded.

It is preferable for the method for bonding metal bodies related to the invention that the second material to be bonded is a metal body having a processed layer that has been subjected to a processing for creating atomic vacancies and/or dislocations.

It is preferable for the method for bonding metal bodies related to the invention that the processed layer is formed only in a section that is bonded by the fine metal particles between the materials to be bonded.

Furthermore, it is preferable for the method for bonding metal bodies related to the invention that the fine metal particles are in the form of a paste produced with an organic solvent.

Furthermore, it is preferable for the method for bonding metal bodies related to the invention that the fine metal particles have an average particle size of primary particles of from 1 nm to 500 nm.

In order to achieve the object such as described above, the bonding structure of a metal body according to the invention has a first material to be bonded, which is formed from a metal and has a processed layer having atomic vacancies and/or dislocations in at least one of main surfaces; a sintered body of fine metal particles formed on the processed layer; and a second material to be bonded, which is bonded with the first material to be bonded by means of the sintered body of fine metal particles. The process for creating atomic vacancies and/or dislocations is mechanical processing or radiation damage by irradiation with particle beams. A Vickers hardness number of the processed layer is higher by Hv 50 or more than a Vickers hardness number of the metal before processing and is from Hv 80 to Hv 120. The Vickers hardness number of the processed layer can be checked by the Vickers hardness test of JIS Z 2244, in case in which the layer is less than 1 µm thick by nanoindentation. A thickness of the processed layer is 0.5 µm or more. The first material to be bonded is formed from copper or a copper alloy, silver plating or gold plating. The fine metal particles are fine particles of one metal selected from a metal element group consisting of silver, gold, copper, aluminum, nickel, platinum, tin, antimony and palladium; fine particles obtained by mixing two or more kinds selected from the metal element group; fine particles formed from an alloy of two or more elements selected from the metal element group; fine particles obtained by mixing fine particles of one metal selected from the metal element group or fine particles produced by mixing two or more kinds selected from the metal element group, with fine particles formed from an alloy of two or more elements selected from the metal element group; or an oxide of these fine particles. The processed layer of the first material to be bonded is recrystallized by heating the first material to be bonded to a temperature higher than or equal to the recrystallization temperature of the processed layer of the first material to be bonded.

### EFFECT OF THE INVENTION

According to the method for bonding metal bodies of the invention, when a laminate composed of a first material to be bonded, a second material to be bonded, and fine metal particles is heated, the phenomenon of melting occurs locally at the surface of the fine metal particles, and a bonded part (neck) is formed between the fine metal particles themselves and between the fine metal particles and the first material to be bonded. At this time, since the first material to be bonded, which is a metal body, has a processed layer that has been subjected to a processing for creating atomic vacancies and/or dislocations in at least the surface, diffusion caused by the atomic vacancies of the processed layer that migrate to the entirety of the material to be bonded or to the fine metal particles, is accelerated between the fine metal particles and the first material to be bonded, similarly to the necks between the fine metal particles themselves, and the fine metal particles and the necks between them are growing. Therefore, higher adhesive force is obtained, and bonding is enabled at a lower temperature.

### BRIEF DESCRIPTION OF DRAWINGS

Fig. 1 is an explanatory diagram for schematically explaining the method for bonding metal bodies according to an embodiment of the invention;
Fig. 2 is an explanatory diagram for schematically explaining the action of method for bonding metal bodies according to the embodiment of the invention;
Fig. 3 is an explanatory diagram for schematically explaining the method for bonding metal bodies according to another embodiment of the invention; and
Fig. 4 is an explanatory diagram for schematically explaining the action of the method for bonding metal bodies according to the embodiment of the invention.

### MODE(S) FOR CARRYING OUT THE INVENTION

Embodiments of the invention will be explained in detail below based on the drawings.

### (First embodiment)

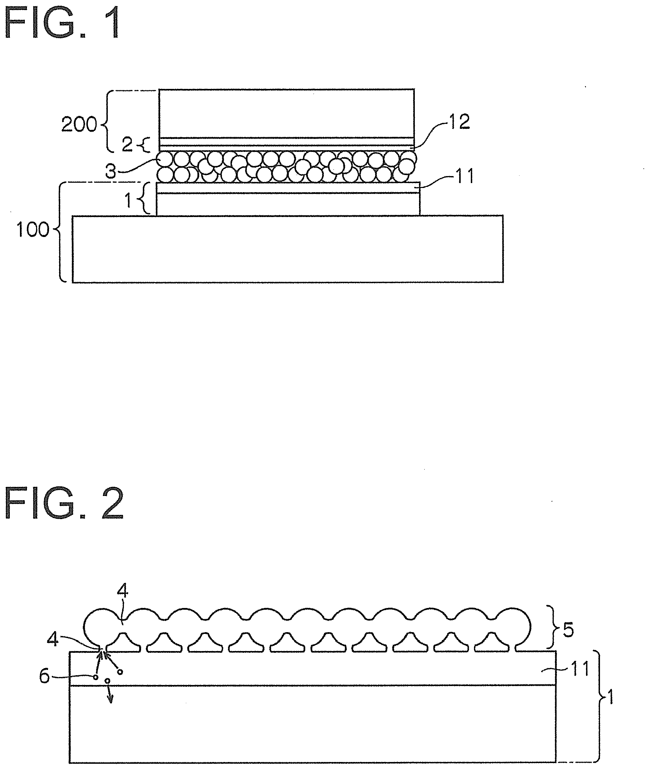

As illustrated in Fig.1, the method for bonding metal bodies according to the present embodiment includes a step of preparing a first material to be bonded 1 and a second material to be bonded 2 which are made of metal bodies, both respectively having, on the surface, processed layers 11 and 12 which have been subjected to a processing for creating atomic vacancies and/or dislocations; a step of supplying fine metal particles 3 between the processed layer 11 of the first material to be bonded 1 and the processed layers 12 of the second material to be bonded 2; and a step of bonding the first material to be bonded 1 and the second material to be bonded 2 by heating a laminate composed of the first material to be bonded 1, the second material to be bonded 2, and the fine metal particles 3.

The first material to be bonded 1 is not particularly limited as long as it is a metal body having electrical conductivity; however, for example, the first material to be bonded 1 is an electrode of a substrate 100 such as a circuit board or a ceramic substrate, and is preferably formed from copper or a copper alloy, silver plating or gold plating. Furthermore, regarding the substrate 100, a DBC (Direct Bonding Copper) substrate and an AMC (Active-metal brazed copper) substrate, which are products obtained by bonding a copper plate with a ceramic substrate, can be used. Meanwhile, for the ceramic of the DBC substrate, alumina (Al₂O₃) may be used, and for the ceramic of the AMC substrate, silicon nitride (Si₃N₄) or aluminum nitride (AlN) may be used.

According to the present embodiment, the second material to be bonded 2 is also a metal body. For example, the second material to be bonded 2 is an electrode of a semiconductor element 200, and is preferably a product in which Ni or a Ni alloy, and Au or an Au alloy is formed on Ti or a Ti alloy.

Meanwhile, in the example described above, an electrode of a semiconductor element 200 and an electrode of a substrate 100 are connected; however, instead of the substrate, a die pad for a lead frame and the back surface of the semiconductor element may be connected, or the method may also be applied to a so-called chip-on-chip structure, in which a semiconductor element and another semiconductor element are connected. Furthermore, bonding of electrodes of semiconductor elements may be bump bonding , or may be pin bonding as microbonding.

According to the present embodiment, the surfaces of the first material to be bonded 1 and the second material to be bonded 2 are subjected to a processing for creating atomic vacancies and/or dislocations, and the processed layers 11 and 12 are formed. The process for forming the processed layers 11 and 12 are not particularly limited as long as the processing produces atomic vacancies and/or dislocations at the surfaces of the first material to be bonded 1 and the second material to be bonded 2, and for example, it is preferable to achieve the formation by mechanical processing such as blasting or buff polishing. However, the surfaces may also be subjected to radiation damage by irradiation with particle beams. For example, a processed layer having a thickness of 5 µm can be obtained by performing a treatment at a gauge pressure of 0.15 MPa and a throughput speed of 5 mm/sec, through a wet blasting method of using a medium formed from alumina material, having a polygonal shape, and having a median particle size of 14 µm. Meanwhile, in a case in which the second material to be bonded 2 is a back surface of a semiconductor element, the second material to be bonded 2 may not have a processed layer 12.

Furthermore, the processed layers 11 and 12 may also be formed only in the sections that are bonded by the fine metal particles 3 in the surfaces of the first material to be bonded 1 and the second material to be bonded 2. For example, in a case in which the first material to be bonded 1 is an electrode of a substrate 100, the electrode of the substrate 100 has not only sections that are die-bonded, but also sections that are wire-bonded. In a case in which an aluminum material or the like, in which rapid diffusion occurs, is used as a wire material, when diffusion is accelerated, defects such as Kirkendall voids are likely to be formed. Therefore, it is preferable not to form the processed layer 11 at the section that is wire-bonded.

Thicknesses of the processed layers 11 and 12 are not particularly limited; however, the thicknesses are preferably from 0.5 µm to 10 µm. Furthermore, regarding the extent of the processing, it is preferable that the Vickers hardness number(Hv) of the processed layers 11 and 12 is higher by Hv 50 or more than the Vickers hardness number before processing in order to lower the temperature at which connection is enabled. Also, it is more preferable that the hardness number of the processed layers 11 and 12 is from Hv 80 to Hv 120.

In a case in which the hardness of the processed layers 11 and 12 is highly only by less than Hv 50 compared to the hardness number before processing of a copper plate, which is a material to be bonded, the temperature at which connection is enabled is not sufficiently lowered. Also, in a case in which the hardness number of the processed layers 11 and 12 is less than Hv 80, it is similarly difficult for the temperature at which connection is enabled to be sufficiently lowered. In a case in which the hardness number is more than Hv 120, as the recrystallization temperature is lowered, the vacancies released by recrystallization of the processed layer accelerate diffusion at the temperature at which sintering of the fine metal particles proceeds, and thereby the effect of accelerating sintering is decreased, which is not preferable.

The Vickers hardness number of the processed layers 11 and 12 can be checked by the Vickers hardness test (micro-Vickers hardness test) of JIS Z 2244, and evaluation and verification can be carried out using a micro-Vickers hardness tester (for example, micro-Vickers hardness tester HM-102 manufactured by Mitutoyo Corporation).

Furthermore, in a case in which the processed layers 11 and 12 are thin (for example, having a thickness of about 1 µm or less), measurement by nano-indentation may be carried out (for example, the experimental method according to OS15-11 "Fundamental Study on Mechanical Property Evaluation of Crystal Grain by Nano-indentation", the 61st National Congress of Theoretical and Applied Mechanics, March 2012, may be used). The evaluation and verification on the Vickers hardness (Hv) can be carried out by multiplying the nano-indentation hardness (Hit) obtained by the nano-indentation described above, by 0.0924.

In regard to the hardness of the processed layers 11 and 12, in the case of the wet blasting method, desired hardness can be obtained by regulating the pressure or the throughput speed. For example, when a copper plate (oxygen-free copper) having a hardness number before processing of Hv 34 was treated at a gauge pressure of 0.15 MPa and a throughput speed of 5 mm/sec, using an alumina medium having a polygonal shape and having a median particle size of 14 µm, it was confirmed that the hardness number of the processed layer thus formed as Hv 84. Furthermore, when the gauge pressure was adjusted to 0.20 MPa so as to increase the hardness of the processed layers, the hardness number of the processed layers could be increased to Hv 120.

The fine metal particles 3 are preferably fine particles of one metal selected from a metal element group consisting of silver, gold, copper, aluminum, nickel, platinum, tin, antimony and palladium; fine particles obtained by mixing two or more kinds selected from the aforementioned metal element group; fine particles formed from an alloy of two or more elements selected from the metal element group; fine particles obtained by mixing fine particles of one metal selected from the metal element group or fine particles obtained by mixing two or more kinds selected from the metal element group, with fine particles formed from an alloy of two or more elements selected from the metal element group; or oxides of these fine particles. Furthermore, the fine metal particles may be fine particles formed from oxides of the metals described above, or may be fine particles formed from oxides of the alloys described above, and oxidation may occur in a portion of the fine particles.

Furthermore, the average particle size (average particle size of primary particles) of the fine metal particles 3 is preferably from 1 nm to 500 nm, and more preferably from 5 nm to 200 nm. Here, the average particle size of primary particles means the average of diameters of primary particles, which are individual fine metal particles 3 that constitute secondary particles. This primary particle size can be measured using an electron microscope. Furthermore, the average particle size means the number average particle size of primary particles. When fine metal particles 3 having an average particle size of primary particles of from 1 nm to 500 nm are included at a predetermined proportion, preferably at a proportion of from 30% to 90% of the total mass, fine metal particles having a particle size of from 0.5 µm to 50 µm may also be included in addition to those.

It is preferable that the fine metal particles 3 are in the form of a paste produced using an organic solvent. Regarding the organic solvent, any known organic solvent can be appropriately used; however, a preferred example thereof is an alcohol and/or a polyhydric alcohol that is liquid at 25°C, and a mixture of an alcohol and/or a polyhydric alcohol, which are liquid at 25°C, and an alcohol and/or a polyhydric alcohol, which are solid at 25°C.

In addition to that, a dispersion aid substance or a solvent may be appropriately incorporated therein. Regarding the dispersion aid substance, any known dispersion aid substance can be appropriately used; however, in consideration of enhancing dispersibility and sinterability of the fine metal particles 3, it is preferable to use a compound having an amide group, an amine compound, or the like.

The fine metal particles 3 are supplied onto the processed layer 11 of the first material to be bonded 1, and the second material to be bonded 2 is placed thereon such that the processed layer 12 is brought into contact with the fine metal particles 3. The fine metal particles 3 are sintered in this state. Sintering of the fine metal particles 3 is desirably carried out in a reducing atmosphere or in an inert atmosphere. An inert atmosphere means an atmosphere filled with a gas such as nitrogen, or a vacuum atmosphere. Thereby, the oxide layer at the surface of the fine metal particles 3 is removed, and sinterability of the fine metal particles 3 can be enhanced. Furthermore, sintering may be carried out while pressure is appropriately applied, depending on the properties of the organic solvent incorporated into the fine metal particles 3. Sintering is preferably carried out for a time between 30 minutes and 90 minutes, by heating to a temperature higher than or equal to the recrystallization temperature of the processed layer 12, and pressurizing the system at a pressure of from 0 MPa to 20 MPa.

In a case in which it is desirable to perform sintering of the fine metal particles 3 by heat-treating the fine metal particles 3 under pressure, the organic solvent may be volatilized as a result of the heat treatment, and the decrease in the occupied volume of the fine metal particles 3 may become large. In a case in which the decrease in the occupied area of the fine metal particles 3 becomes significant due to the heat treatment, the metal density can be increased by pressurization. Furthermore, formation of cracks in a sintered body of the fine metal particles 3 can be prevented. Furthermore, by applying pressure, the first material to be bonded 1 and the second material to be bonded 2 can be bonded more strongly.

On the other hand, in a case in which the occupied area of the fine metal particles 3 hardly changes even if the fine metal particles are heat-treated, sintering of the fine metal particles 3 can be carried out by heating treating the fine metal particles without applying pressure.

When a laminate composed of the first material to be bonded 1, the second material to be bonded 2, and the fine metal particles 3 is at least heated, the phenomenon of melting occurs locally at the surface of the fine metal particles 3. As illustrated in Fig. 2, a bonded part (neck 4) is formed between the fine metal particles 3 themselves and between the fine metal particles 3 and the first material to be bonded 1 (metal body), and a fused layer 5 in which the fine metal particles 3 are fused, and the bonding surface of the first material to be bonded 1 and the fine metal particles 3 are fused, is formed. At this time, since the first material to be bonded 1 has a processed layer 11 that has been subjected to a processing for creating atomic vacancies and/or dislocations on the surface, in the neck 4 between the fine metal particles 3 and the first material to be bonded 1, diffusion resulting from the migration of the atomic vacancies of the processed layer to the entirety of the material to be bonded or to the fine metal particles, is accelerated, and the fine metal particles and the neck grow. Therefore, higher adhesive force is obtained, and bonding is enabled at a lower temperature. Thereby, a recrystallized layer is formed on the surface of the first material to be bonded 1.

Furthermore, since the processed layer 11 is provided on the surface of the first material to be bonded 1, the efficiency of the diffusion reaction is increased compared to the case of using a conventional material to be bonded in which the processed layer 11 is not provided on the surface, and therefore, the recrystallization temperature of the fine metal particles 3 becomes lower than that in the case of using a conventional material to be bonded in which the processed layer 11 is not provided on the surface. Thus, bonding at a lower temperature is enabled. For example, in a case in which the fine metal particles 3 are formed from copper, the recrystallization temperature is usually 200°C or higher; however, in a case in which the fine metal particles 3 are bonded with the first material to be bonded 1 in which the processed layer 11 is provided on the surface, the recrystallization temperature is 150°C or higher. As such, sintering is enabled at a low temperature, and as a result, the bonding strength at the connected interface is increased.

By carrying out the processes described above, the bonding structure of a metal body related to the invention is obtained. That is, the bonding structure of a metal body related to the invention has a first material to be bonded 1, which is formed from a metal and has a processed layer having atomic vacancies and/or dislocations on at least one of main surfaces; a sintered body of fine metal particles formed on the processed layer; and a second material to be bonded 2, which is bonded with the first material to be bonded by means of the sintered body of fine metal particles. Furthermore, according to a preferred method for bonding a metal body related to the invention, a bonding structure of a metal body, in which the processed layer is formed only on the surface of the first material to be bonded 1, and the Vickers hardness number of the processed layer is higher by Hv 50 or more than the Vickers hardness number of a region in the first material to be bonded, in which the processed layer is not formed, is obtained. Furthermore, a bonding structure of a metal body in which the Vickers hardness number of the processed layer is from Hv 80 to Hv 120, is obtained.

Meanwhile, in the description given above, the relationship between the first material to be bonded 1 and the fine metal particles 3 has been explained; however, the relationship between the second material to be bonded 2 and the fine metal particles 3 is also the same.

### (Second embodiment)

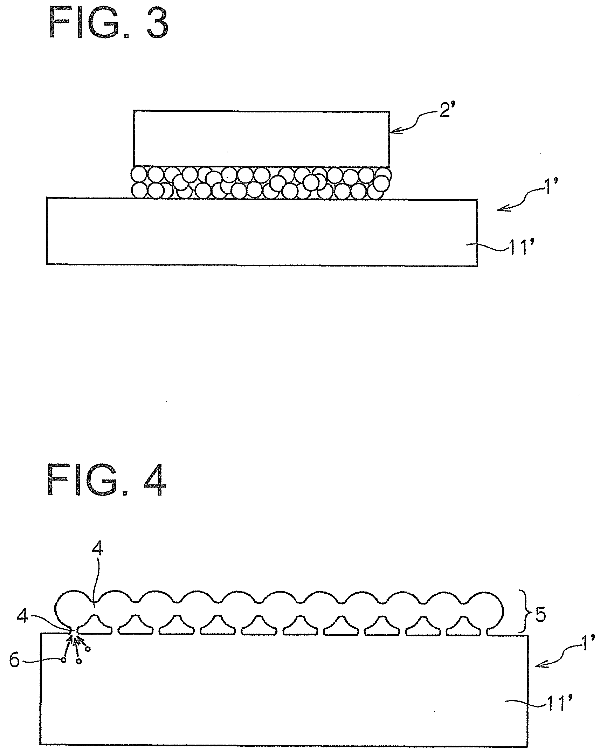

Next, the second embodiment will be explained using Fig. 3. While the first embodiment described above has the processed layer 1 provided only on the surface of the first material to be bonded 1, the same configuration and bonding method as those explained for the first embodiment can be applied in the present embodiment, except that a processed layer 11' is provided over the entire surface of a first material to be bonded 1'.

Hereinafter, the difference between the second embodiment and the first embodiment will be explained. As illustrated in Fig. 3, the first material to be bonded 1' has been subjected to a processing for creating atomic vacancies and/or dislocations over the entire area in the thickness direction, and the first material to be bonded 1' is formed only of the processed layer 11'. In order to produce atomic vacancies and/or dislocations over the entire area in the thickness direction of the first material to be bonded 1', for example, bending may be attempted.

The first material to be bonded 1' is, for example, a die pad for a lead frame, and in this case, the second material to be bonded 2' is the back surface of a semiconductor element.

As illustrated in Fig. 3, when fine metal particles 3 are supplied over the first material to be bonded 1', a second material to be bonded 2' is placed thereon, and the assembly is heated in that state, similarly to the first embodiment, a bonded part (neck 4) is formed between the fine metal particles 3 themselves and between the fine metal particles 3 and the first material to be bonded 1' (metal body), as illustrated in Fig. 4. At this time, since the first material to be bonded 1 is a processed layer 11' that has been subjected to a processing for creating atomic vacancies and/or dislocations, in the neck 4 between the fine metal particles 3 and the first material to be bonded 1', diffusion resulting from the migration of the atomic vacancies of the processed layer to the entirety of the material to be bonded or to the fine metal particles is accelerated, and the fine metal particles and the necks between them grow. Therefore, higher adhesive force is obtained, and bonding at a lower temperature is enabled.

Furthermore, since the first material to be bonded 1' is formed of the processed layer 11', the diffusion reaction occurs rapidly compared to the case in which a conventional material to be bonded that is not provided with the processed layer 11'. Therefore, the recrystallization temperature of the fine metal particles 3 becomes lower than that in the case of using a conventional material to be bonded that is not provided with the processed layer 11' on the surface, and bonding at a lower temperature is enabled.

In the first embodiment, since the processed layer 11 is provided only on the surface of the first material to be bonded 1, in the first material to be bonded 1, the atomic vacancies diffuse not only to the bonding side (surface) but also to the entirety of the first material to be bonded 1, as illustrated in Fig. 2.

In this regard, in the second embodiment, since the processed layer 11' is provided over the entire area in the thickness of the first material to be bonded 1', in the first material to be bonded 1', the speed at which the atomic vacancies diffuse to the bonding side increases relatively, and migration of the atomic vacancies to the bonding side occurs preferentially, as illustrated in Fig. 3. Therefore, in the second embodiment, the migration of the atomic vacancies is limited to migration to the fine metal particles.

As a result, acceleration of diffusion occurs at higher efficiency in the first embodiment than in the second embodiment, and neck growth or recrystallization between the fine metal particles 3 themselves or between the fine metal particles 3 and the first material to be bonded 1 proceeds. Therefore, the recrystallization temperature can be lowered in the case in which the first material to be bonded 1 in which the processed layer 1 is provided only on the surface is used, rather than the case in which the first material to be bonded 1' in which the processed layer 11' is provided over the entire area in the thickness direction is used. For example, in a case in which the fine metal particles 3 were formed from copper, the recrystallization temperature at the time of bonding the fine metal particles 3 with the first material to be bonded 1' in which the processed layer 11' is provided over the entire area in the thickness direction, was 180°C or higher, whereas the recrystallization temperature at the time of bonding the fine metal particles 3 with the first material to be bonded 1 in which the processed layer 11 is provided only on the surface, was 150°C.

By carrying out the processes described above, a bonding structure of a metal body having a first material to be bonded 1', which is formed from a metal and is provided with a processed layer 11' having atomic vacancies and/or dislocations over the entire area in the thickness direction; a sintered body of fine metal particles formed on the processed layer 11'; and a second material to be bonded 2', which is bonded with the first material to be bonded by means of the sintered body of fine metal particles, is obtained.

### EXPLANATIONS OF LETTERS OR NUMERALS

1, 1': First material to be bonded
11, 11': Processed layer
2, 2': Second material to be bonded
22, 22': Processed layer
3: Fine metal particles
4: Neck
5: Fused layer
6: Atomic vacancies
100: Substrate
200: Semiconductor element

## Claims

1. A method for bonding metal bodies, the method comprising:
preparing a first material to be bonded, the first material to be bonded being formed from a metal and having a processed layer subjected to a processing for creating atomic vacancies and/or dislocations;
supplying fine metal particles between the processed layer of the first material to be bonded and a second material to be bonded; and
bonding the first material to be bonded and the second material to be bonded by means of the fine metal particles,
wherein the process for creating atomic vacancies and/or dislocations is mechanical processing or radiation damage by irradiation with particle beams;
a Vickers hardness number of the processed layer is higher by Hv 50 or more than a Vickers hardness number of the metal before processing,
the Vickers hardness number of the processed layer is from Hv 80 to Hv 120,
wherein the Vickers hardness number of the processed layer can be checked by the Vickers hardness test of JIS Z 2244, in case in which the layer is less than 1 µm thick by nanoindentation;
a thickness of the processed layer is 0.5 µm or more;
the first material to be bonded is formed from copper or a copper alloy, silver plating or gold plating;
fine metal particles are fine particles of one element selected from a metal element group consisting of silver, gold, copper, aluminum, nickel, platinum, tin, antimony and palladium, fine particles formed by mixing two or more kinds selected from the metal element group; fine particles formed from an alloy of two or more elements selected from the metal element group; fine particles obtained by mixing fine particles of one element selected from the metal element group or fine particles formed by mixing two or more kinds selected from the metal element group, with fine particles formed from an alloy of two or more elements selected from the metal element group; or an oxide thereof,
the processed layer of the first material to be bonded is recrystallized by heating the first material to be bonded, to a temperature higher than or equal to the recrystallization temperature of the processed layer of the first material to be bonded.

2. The method for bonding metal bodies according to claim 1, wherein the processed layer is formed only on the surface of the material to be bonded.

3. The method for bonding metal bodies according to claim 1 or 2, wherein the second material to be bonded is a metal body having a processed layer, the processed layer having been subjected to a processing for creating atomic vacancies and/or dislocations.

4. The method for bonding metal bodies according to any one of claims 1 to 3, wherein the processed layer is formed only in a section bonded by the fine metal particles in the materials to be bonded.

5. The method for bonding metal bodies according to any one of claims 1 to 4, wherein the fine metal particles have an average particle size of primary particles of from 1 nm to 500 nm.

6. The method for bonding metal bodies according to claim 5, wherein the fine metal particles are in the form of a paste produced using an organic solvent.

7. A bonding structure of metal bodies, the bonding structure comprising:
a first material to be bonded, being formed from a metal and having a processed layer having atomic vacancies and/or dislocations on at least one of main surfaces;
a sintered body of fine metal particles formed on the processed layer; and
a second material to be bonded, being bonded with the first material to be bonded by means of the sintered body of fine metal particles,
wherein the process for creating atomic vacancies and/or dislocations is mechanical processing or radiation damage by irradiation with particle beams;
a Vickers hardness number of the processed layer is higher by Hv 50 or more than a Vickers hardness number of the metal before processing
a Vickers hardness number of the processed layer is from Hv 80 to Hv 120,
wherein the Vickers hardness number of the processed layer can be checked by the Vickers hardness test of JIS Z 2244, in case in which the layer is less than 1µm thick by nanoindentation;
a thickness of the processed layer is 0.5 µm or more;
the first material to be bonded is formed from copper or a copper alloy, silver plating or gold plating;
fine metal particles are fine particles of one element selected from a metal element group consisting of silver, gold, copper, aluminum, nickel, platinum, tin, antimony and palladium, fine particles formed by mixing two or more kinds selected from the metal element group; fine particles formed from an alloy of two or more elements selected from the metal element group; fine particles obtained by mixing fine particles of one element selected from the metal element group or fine particles formed by mixing two or more kinds selected from the metal element group, with fine particles formed from an alloy of two or more elements selected from the metal element group; or an oxide thereof;
the processed layer of the first material to be bonded is recrystallized by heating the first material to be bonded, to a temperature higher than or equal to the recrystallization temperature of the processed layer of the first material to be bonded.

## Patentansprüche

1. Verfahren zum Verbinden von Metallkörpern, wobei das Verfahren folgende Schritte umfasst:
Vorbereiten eines ersten zu verbindenden Materials, wobei das erste zu verbindende Material aus einem Metall gebildet ist und eine bearbeitete Schicht aufweist,
welche nach einem Bearbeitungsverfahren zur Erzeugung von atomaren Leerstellen und/oder Umlagerungen bearbeitet ist;
Einbringen von feinen Metallteilchen zwischen die bearbeitete Schicht des ersten zu verbindenden Materials und ein zweites zu verbindendes Material; und
Verbinden des ersten zu verbindenden Materials und des zweiten zu verbindenden Materials mit Hilfe der feinen Metallteilchen,
wobei das Bearbeitungsverfahren zur Erzeugung von atomaren Leerstellen und/oder Umlagerungen eine mechanische Bearbeitung oder ein Bestrahlungsschaden durch Bestrahlung mit Teilchenstrahlen ist;
wobei eine Vickershärte der bearbeiteten Schicht um Hv 50 oder mehr höher als eine Vickershärte des Metalls vor der Bearbeitung ist,
wobei die Vickershärte der bearbeiteten Schicht Hv 80 bis Hv 120 beträgt,
wobei die Vickershärte der bearbeiteten Schicht durch die Härteprüfung nach Vickers nach JIS Z 2244 und, wenn die Schicht geringer als 1 µm dick ist, durch Nanoindentierung überprüfbar ist;
wobei eine Dicke der bearbeiteten Schicht 0,5 µm oder mehr beträgt;
wobei das erste zu verbindende Material aus Kupfer oder einer Kupferlegierung, einer Silberplattierung oder einer Goldplattierung gebildet ist;
wobei feine Metallteilchen feine Teilchen eines Elements sind, welches aus einer Silber, Gold, Kupfer, Aluminium, Nickel, Platin, Zinn, Antimon und Palladium umfassenden Metallelementegruppe ausgewählt ist, feine Teilchen sind, die durch Mischen von zwei oder mehr aus der Metallelementegruppe ausgewählten Elementen gebildet sind; feine Teilchen sind, die aus einer Legierung von zwei oder mehr aus der Metallelementegruppe ausgewählten Elementen gebildet sind; feine Teilchen sind, die durch Mischen von feinen Teilchen eines aus der Metallelementegruppe ausgewählten Elements oder durch Mischen von feinen Teilchen, die durch Mischen von zwei oder mehr aus der Metallelementegruppe ausgewählten Elementen gebildet sind, mit feinen Teilchen, die aus einer Legierung von zwei oder mehr aus der Metallelementegruppe ausgewählten Elementen gebildet sind, erhalten werden; oder ein Oxid derselben sind,
wobei die bearbeitete Schicht des ersten zu verbindenden Materials durch Erwärmung des ersten zu verbindenden Materials auf eine Temperatur, die höher als die oder gleich der Rekristallisationstemperatur der bearbeiteten Schicht des ersten zu verbindenden Materials ist, rekristallisiert ist.

2. Verfahren zum Verbinden von Metallkörpern nach Anspruch 1, wobei die bearbeitete Schicht nur auf der Oberfläche des zu verbindenden Materials gebildet wird.

3. Verfahren zum Verbinden von Metallkörpern nach Anspruch 1 oder 2, wobei das zweite zu verbindende Material ein eine bearbeitete Schicht aufweisender Metallkörper ist, wobei die bearbeitete Schicht nach einem Bearbeitungsverfahren zur Erzeugung von atomaren Leerstellen und/oder Umlagerungen bearbeitet ist.

4. Verfahren zum Verbinden von Metallkörpern nach einem der Ansprüche 1 bis 3, wobei die bearbeitete Schicht nur in einem Abschnitt gebildet wird, der durch die feinen Metallteilchen in den zu verbindenden Materialien verbunden ist.

5. Verfahren zum Verbinden von Metallkörpern nach einem der Ansprüche 1 bis 4, wobei die feinen Metallteilchen eine durchschnittliche Teilchengröße von Primärteilchen von 1 nm bis 500 nm aufweisen.

6. Verfahren zum Verbinden von Metallkörpern nach Anspruch 5, wobei die feinen Metallteilchen in Form einer Paste vorliegen, die mit Hilfe eines organischen Lösungsmittels hergestellt ist.

7. Verbindungsstruktur von Metallkörpern, wobei die Verbindungsstruktur Folgendes umfasst:
ein erstes zu bindendes Material, welches aus einem Metall gebildet ist und eine bearbeitete Schicht aufweist, welche atomare Leerstellen und/oder Umlagerungen an mindestens einer Hauptoberfläche aufweist;
einen Sinterkörper aus auf der bearbeiteten Schicht gebildeten feinen Metallteilchen; und
ein zweites zu verbindendes Material, welches mit dem ersten zu verbindenden Material durch den Sinterkörper aus feinen Metallteilchen verbunden ist,
wobei die Bearbeitung zur Erzeugung von atomaren Leerstellen und/oder Umlagerungen eine mechanische Bearbeitung oder ein Bestrahlungsschaden durch Bestrahlung mit Teilchenstrahlen ist;
wobei eine Vickershärte der bearbeiteten Schicht um Hv 50 oder mehr höher als eine Vickershärte des Metalls vor der Bearbeitung ist,
wobei eine Vickershärte der bearbeiteten Schicht Hv 80 bis Hv 120 beträgt,
wobei die Vickershärte der bearbeiteten Schicht durch die Härteprüfung nach Vickers nach JIS Z 2244 und, wenn die Schicht geringer als 1 µm dick ist, durch Nanoindentierung überprüfbar ist;
wobei eine Dicke der bearbeiteten Schicht 0,5 µm oder mehr beträgt;
wobei das erste zu verbindende Material aus Kupfer oder einer Kupferlegierung, einer Silberplattierung oder einer Goldplattierung gebildet ist;
wobei feine Metallteilchen feine Teilchen eines Elements sind, welches aus einer Silber, Gold, Kupfer, Aluminium, Nickel, Platin, Zinn, Antimon und Palladium umfassenden Metallelementegruppe ausgewählt ist, feine Teilchen sind, die durch Mischen von zwei oder mehr aus der Metallelementegruppe ausgewählten Elementen gebildet sind; feine Teilchen sind, die aus einer Legierung von zwei oder mehr aus der Metallelementegruppe ausgewählten Elementen gebildet sind; feine Teilchen sind, die durch Mischen von feinen Teilchen eines aus der Metallelementegruppe ausgewählten Elements oder durch Mischen von feinen Teilchen, die durch Mischen von zwei oder mehr aus der Metallelementegruppe ausgewählten Elementen gebildet sind, mit feinen Teilchen, die aus einer Legierung von zwei oder mehr aus der Metallelementegruppe ausgewählten Elementen gebildet sind; erhalten werden, oder ein Oxid derselben sind,
wobei die bearbeitete Schicht des ersten zu verbindenden Materials durch Erwärmung des ersten zu verbindenden Materials auf eine Temperatur, die höher als die oder gleich der Rekristallisationstemperatur der bearbeiteten Schicht des ersten zu verbindenden Materials ist, rekristallisiert ist.

## Revendications

1. Procédé de liaison de corps métalliques, le procédé comprenant :
préparer un premier matériau à lier, le premier matériau à lier étant formé d'un métal et ayant une couche traitée qui a été soumise à un traitement dans lequel des lacunes atomiques et/ou des réarrangements atomiques sont créés ;
introduire des particules métalliques fines entre la couche traitée du premier matériau à lier et un deuxième matériau à lier ; et
lier le premier matériau à lier et le deuxième matériau à lier au moyen des particules métalliques fines,
dans lequel le traitement dans lequel des lacunes atomique et/ou des réarrangements atomiques sont créés est un traitement mécanique ou un dommage causé par l'irradiation avec des faisceaux de particules ;
une dureté Vickers de la couche traitée est au moins Hv 50 plus élevée qu'une dureté Vickers du métal avant le traitement,
la dureté Vickers de la couche traitée est de Hv 80 à Hv 120,
dans lequel la dureté Vickers de la couche traitée est contrôlable par l'essai de dureté Vickers selon JIS Z 2244 et, si la couche a moins de 1 µm d'épaisseur, par la nanoindentation ;
une épaisseur de la couche traitée est 0,5 µm ou plus ;
le premier matériau à lier est formé de cuivre ou d'un alliage de cuivre, d'une argenture ou d'une dorure ;
des particules métalliques fines sont des particules fines d'un élément choisi dans un groupe d'éléments métalliques comprenant l'argent, l'or, le cuivre, l'aluminium,
le nickel, le platine, l'étain, l'antimoine et le palladium, des particules fines formées en mélangeant deux ou plus éléments choisis dans le groupe d'éléments métalliques, des particules fines formées d'un alliage de deux ou plus éléments choisis dans le groupe d'éléments métalliques ; des particules fines obtenues en mélangeant des particules fines d'un élément choisi d'un groupe d'éléments métalliques ou des particules fines formées en mélangeant deux ou plus éléments choisis dans le groupe d'éléments métalliques, avec des particules fines formées d'un alliage de deux ou plus éléments choisis dans le groupe d'éléments métalliques ; ou un oxyde de ceux-ci,
la couche traitée du premier matériau à lier est recristallisée par le chauffage du premier matériau à lier à une température supérieure ou égale à la température de recristallisation de la couche traitée du premier matériau à lier.

2. Procédé de liaison de corps métalliques selon la revendication 1, dans lequel la couche traitée n'est formée que sur la surface du matériau à lier.

3. Procédé de liaison de corps métalliques selon la revendication 1 ou 2, dans lequel le deuxième matériau à lier est un corps métallique ayant une couche traitée, la couche traitée ayant été soumise à un traitement dans lequel des lacunes atomiques et/ou des réarrangements atomiques sont créés.

4. Procédé de liaison de corps métalliques selon l'une quelconque des revendications 1 à 3, dans lequel la couche traitée n'est formée que dans une section liée par les particules métalliques fines dans les matériaux à lier.

5. Procédé de liaison de corps métalliques selon l'une quelconque des revendications 1 à 4, dans lequel les particules métalliques fines ont une taille moyenne des particules primaires de 1 nm à 500 nm.

6. Procédé de liaison de corps métalliques selon la revendication 5, dans lequel les particules métalliques fines sont sous la forme d'une pâte produite en utilisant un solvant organique.

7. Structure de liaison de corps métalliques, la structure de liaison comprenant :
un premier matériau à lier étant formé d'un métal et ayant une couche traitée ayant des lacunes atomiques et/ou des réarrangements atomiques sur au moins une des surfaces principales ;
un corps fritté de particules métalliques fines formé sur la couche traitée ; et
un deuxième matériau à lier étant lié au premier matériau à lier au moyen du corps fritté de particules métalliques fines,
dans lequel le traitement dans lequel des lacunes atomique et/ou des réarrangements atomiques sont créés est un traitement mécanique ou un dommage causé par l'irradiation avec des faisceaux de particules ;
une dureté Vickers de la couche traitée est au moins Hv 50 plus élevée qu'une dureté Vickers du métal avant le traitement,
une dureté Vickers de la couche traitée est de Hv 80 à Hv 120,
dans lequel la dureté Vickers de la couche traitée est contrôlable par l'essai de dureté Vickers selon JIS Z 2244 et, si la couche a moins de 1 µm d'épaisseur, par la nanoindentation ;
une épaisseur de la couche traitée est 0,5 µm ou plus ;
le premier matériau à lier est formé de cuivre ou d'un alliage de cuivre, d'une argenture ou d'une dorure ;
des particules métalliques fines sont des particules fines d'un élément choisi dans un groupe d'éléments métalliques comprenant l'argent, l'or, le cuivre, l'aluminium,
le nickel, le platine, l'étain, l'antimoine et le palladium, des particules fines formées en mélangeant deux ou plus éléments choisis dans le groupe d'éléments métalliques ; des particules fines formées d'un alliage de deux ou plus éléments choisis dans le groupe d'éléments métalliques ; des particules fines obtenues en mélangeant des particules fines d'un élément choisi d'un groupe d'éléments métalliques ou des particules fines formées en mélangeant deux ou plus éléments choisis dans le groupe d'éléments métalliques, avec des particules fines formées d'un alliage de deux ou plus éléments choisis dans le groupe d'éléments métalliques ; ou un oxyde de ceux-ci,
la couche traitée du premier matériau à lier est recristallisée par le chauffage du premier matériau à lier à une température supérieure ou égale à la température de recristallisation de la couche traitée du premier matériau à lier.
